# EUROPEAN PATENT APPLICATION

(11) **EP 4 336 258 A1**
(43) Date of publication of application: **13.03.2024**
(21) Application number: 22195223.7
(22) Date of filing: 12.09.2022
(51) Int. Cl.: G03F 1/62

(54) **PELLICLE AND METHODS FOR FORMING PELLICLE FOR USE IN A LITHOGRAPHIC APPARATUS**

(71) Applicant: ASML Netherlands B.V., 5500 AH Veldhoven (NL); IMEC vzw, 3001 Leuven (BE)
(72) Inventor: VERMEULEN, Paul, Alexander, 5500 AH Veldhoven (NL); GALLAGHER, Emily, Elizabeth, 3001 Leuven (BE); POLLENTIER, Ivan, Karel, Arthur, 3001 Leuven (BE); BREMS, Steven, 3001 Leuven (BE)
(74) Representative: ASML Netherlands B.V.

(57) **Abstract**

A pellicle for use in a lithographic apparatus, the pellicle comprising: a membrane, the membrane comprising a first portion and a second portion; and a protective portion at the second portion on at least one side of the membrane. A method for forming a pellicle for use in a lithographic apparatus, the method comprising: providing a membrane comprising a first portion and a second portion, providing a protective portion at the second portion on at least one side of the membrane.

## Description

### FIELD

The present invention relates to a pellicle for use in a lithographic apparatus and associated methods for forming such a pellicle. The present invention also relates to a lithographic apparatus comprising a pellicle disposed in a path of a radiation beam of the lithographic apparatus (used for forming an image on a substrate).

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A patterning device (e.g., a mask) is used to impart a pattern to a radiation beam in a lithographic apparatus. The patterning device may be protected by a pellicle from particle contamination. The pellicle may be supported by a pellicle frame.

A typical pellicle is a membrane which is located away from the patterning device and is out of the focal plane of a lithographic apparatus in use. Because the pellicle is out of the focal plane of the lithographic apparatus, contamination particles which land on the pellicle are out of focus in the lithographic apparatus. Consequently, images of the contamination particles are not projected onto the substrate. If the pellicle were not present, then a contamination particle which landed on the patterning device may be projected onto the substrate and may introduce a defect into the projected pattern.

It may be desirable to provide an apparatus and/or method that obviates or mitigates one or more problems associated with the prior art.

### SUMMARY

According to a first aspect of the present invention, there is provided a pellicle for use in a lithographic apparatus, the pellicle comprising: a membrane, the membrane comprising a first portion and a second portion; and a protective portion at the second portion on at least one side of the membrane.

An advantage is that the lifetime of the pellicle may be increased without affecting the performance of the lithographic apparatus.

The protective portion may be only at or on the second portion. The protective portion may be not at or on the first portion. The protective portion may be at or on the first portion to a lesser extent than at or on the second portion.

The at least one side of the membrane may be a front side of the membrane. That is, the side that the EUV radiation (EUV radiation beam B) is incident on from the radiation source SO and/or illumination system. The front side may be opposite a back side (second side), i.e. the side facing a patterning device in use. The front side may be opposite the side attached to a pellicle frame.

The second portion, in use, may not receive EUV imaging radiation or may receive only a fraction of the EUV imaging radiation received by the first portion.

The second portion may be an unexposed region, e.g. that etches more quickly during exposure.

The first portion may substantially correspond to a predetermined exposure region of a patterning device for use with the pellicle.

The first portion may be substantially the same size as the predetermined exposure region of the patterning device.

The second portion may be at a periphery of the membrane.

The pellicle may comprise a border at the periphery of the membrane, wherein the second portion may coincide with the border.

The protective portion may comprise a material that is suitable to protect the second portion of the membrane from hydrogen etching.

The protective portion may be on at least one of: a first side and an opposite second side of the membrane; and an edge of the membrane.

The protective portion may be on only one side of the membrane (e.g. a front side of the membrane).

The first side of the membrane may be a front side of the membrane. The second side of the membrane may be a back side of the membrane.

The protective portion may comprise a capping material covering the second portion.

The capping material may comprise at least one of: carbon nanotubes, graphene, amorphous carbon, (low melting point metals), molybdenum (Mo), yttrium (Y), yttrium oxide (YₐO_{b}), aluminium oxide (Al₂O₃) (AlO₂), hafnium oxide (HfO₂), zirconium oxide (ZrO₂), ruthenium (Ru), platinum (Pt), gold (Au), zirconium nitride (ZrN), aluminium (Al) zirconium (Zr), silicon (Si), silicon carbide (SiC) silicon oxide (SiOₐ), boron (B), boron carbide (B₄C), boron nitride (BN), titanium (Ti), and titanium nitride (TN).

The membrane may comprise the protective portion and the protective portion may comprise the same material as the first and second portions.

The membrane may comprise carbon nanotubes.

According to a second aspect of the present invention, there is provided a lithographic apparatus operable to form an image of a patterning device on a substrate using a radiation beam, the lithographic apparatus comprising a pellicle disposed in a path of the radiation beam, the pellicle as described above.

According to a third aspect of the present invention, there is provided a method for forming a pellicle for use in a lithographic apparatus, the method comprising: providing a membrane comprising a first portion and a second portion, providing a protective portion at the second portion on at least one side of the membrane.

The method may further comprise providing the protective portion using an additive method or a subtractive method.

The method may further comprise providing the protective portion using an additive method, wherein the protective portion may comprise a capping material; depositing the capping material over the second portion to cover the second portion.

The method may further comprise masking the first portion using a masking element.

The masking element may substantially correspond to a predetermined exposure region of a patterning device for use with the pellicle.

The method may further comprise depositing the capping material using at least one of: thermal evaporation, e-beam evaporation, e-beam deposition, pulsed laser deposition, atomic layer deposition and remote plasma sputtering.

The method may further comprise providing the protective portion using a subtractive method, wherein the protective portion may comprise a capping material; applying the capping material over the first portion and the second portion, and removing the capping material from the first portion.

The method may further comprise removing the capping material from the first portion using at least one of: laser annealing, laser ablating, reactive ion etching, and lift-off.

The capping material may be a volatile or thermally unstable material for being desorbed by EUV radiation.

The method may further comprise providing the protective portion using a subtractive method including providing the membrane with a thickness, and partially removing the first portion to reduce the thickness of the first portion, wherein the membrane may comprise the protective portion and the protective portion may comprise the same material as the first and second portions.

The method may further comprise etching the first portion in hydrogen plasma.

The method may further comprise providing the protective portion on at least one of: a first side and an opposite second side of the membrane; and an edge of the membrane.

The method may further comprise providing the first portion to substantially correspond to a predetermined exposure region of a patterning device for use with the pellicle.

The method may further comprise providing the protective portion during at least one of fabrication of the pellicle, fabrication of a patterning device and fabrication of a substrate.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 schematically depicts a cross section of a pellicle and a patterning device according to an embodiment of the present disclosure;
- Figure 3 schematically depicts a plan view of a pellicle of Figure 2;
- Figure 4 shows an expected etching rate for hydrogen etching of carbon as a function of temperature for a hydrogen ion flux of 1.5 - 1019 m-2 · s-1 for four different ion energies: 5 eV, 10 eV, 20 eV and 30 eV; Figure 4 also shows an sp3 carbon concentration as a function of temperature.
- Figure 5 is a schematic illustration of a method for forming a pellicle according to an embodiment of the present disclosure.

### DETAILED DESCRIPTION

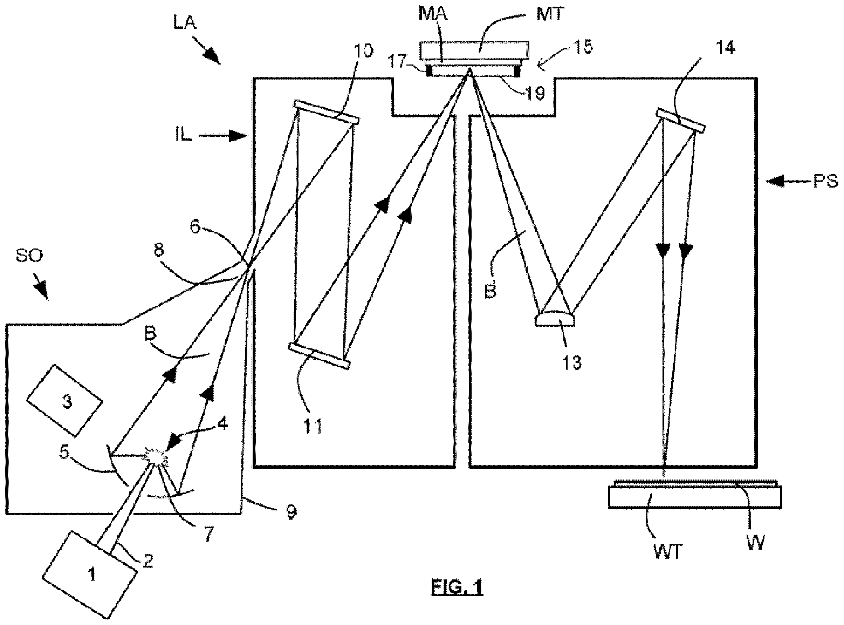

Figure 1 shows a lithographic system including a pellicle 15. The lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA held by the support structure MT. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11. The patterning device MA is protected by a pellicle 15. The pellicle 15 includes a membrane 19 that is held in place by a pellicle frame 17. The membrane 19 and the pellicle frame 17 together form the pellicle 15.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a COz laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during deexcitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

As was described briefly above, the pellicle 15 includes the membrane 19 that is provided adjacent to the patterning device MA. The membrane 19 is provided in the path of the radiation beam B such that radiation beam B passes through the membrane 19 both as it approaches the patterning device MA from the illumination system IL and as it is reflected by the patterning device MA towards the projection system PS. The membrane (or thin film) 19 is substantially transparent to EUV radiation (although it will absorb a small amount of EUV radiation). By EUV transparent membrane or a film substantially transparent for EUV radiation herein is meant that the membrane 19 is transmissive for at least 65% of the EUV radiation, preferably at least 80% and more preferably at least 90% of the EUV radiation. The membrane 19 acts to protect the patterning device MA from particle contamination. The membrane 19 may be herein referred to as an EUV transparent membrane.

Whilst efforts may be made to maintain a clean environment inside the lithographic apparatus LA, particles may still be present inside the lithographic apparatus LA. In the absence of the membrane 19, particles may be deposited onto the patterning device MA. Particles on the patterning device MA may disadvantageously affect the pattern that is imparted to the radiation beam B and therefore the pattern that is transferred to the substrate W. The membrane 19 provides a barrier between the patterning device MA and the environment in the lithographic apparatus LA in order to prevent particles from being deposited on the patterning device MA.

In use, the membrane 19 is positioned at a distance from the patterning device MA that is sufficient that any particles that are incident upon the surface of the membrane 19 are not in the focal plane of the radiation beam B. This separation between the membrane 19 and the patterning device MA, acts to reduce the extent to which any particles on the surface of the membrane 19 impart a pattern to the radiation beam B. It will be appreciated that where a particle is present in the beam of radiation B, but at a position that is not in a focal plane of the beam of radiation B (i.e., not at the surface of the patterning device MA), then any image of the particle will not be in focus at the surface of the substrate W. In the absence of other considerations it may be desirable to position the membrane 19 a considerable distance away from the patterning device MA. However, in practice the space which is available in the lithographic apparatus LA to accommodate the pellicle 15 is limited due to the presence of other components. In some embodiments, the separation between the membrane 19 and the patterning device MA may, for example, be approximately between 1 mm and 10 mm, for example between 1 mm and 5 mm, for example between 2 mm and 3mm (e.g. around 2.5 mm), for example between 2 mm and 2.5 mm. In some embodiments, a separation between the membrane 19 and the patterning device MA may be adjustable.

The pellicle 15 may comprise a border portion. The border portion of the pellicle 15 may be hollow and generally rectangular and the membrane 19 may be bounded by the border portion. As known in the art, one type of pellicle may be formed by deposition of one or more thin layers of material on a generally rectangular silicon substrate. The silicon substrate supports the one or more thin layers during this stage of the construction of the pellicle. Once a desired or target thickness and composition of layers has been applied, a central portion of the silicon substrate is removed by etching (this may be referred to as back etching). A peripheral portion of the rectangular silicon substrate is not etched (or alternatively is etched to a lesser extent than the central portion). This peripheral portion forms the border portion of the final pellicle while the one or more thin layers form the membrane of the pellicle (which is bordered by the border portion). The border portion of the pellicle may be formed from silicon.

Some embodiments of the present disclosure relate to a new type of pellicle and methods of forming such a pellicle.

The pellicle 15 (for example comprising a border) may require some support from the more rigid pellicle frame 17. The pellicle frame 17 may provide two functions. First, the pellicle frame 17 may support and tension the membrane 19. Second, the pellicle frame 17 may facilitate connection of the pellicle 15 to the patterning device (reticle or photomask) MA. It one known arrangement, the pellicle frame 17 may comprise a main, generally rectangular body portion which is glued to the border portion of the pellicle 15 and titanium attachment mechanisms that are glued to the side of this main body. Intermediate fixing members (known as studs) are affixed to the patterning device (reticle) MA. The intermediate fixing members (studs) on the patterning device (reticle) MA may engage (for example releasably engage) with the attachment members of the pellicle frame 17.

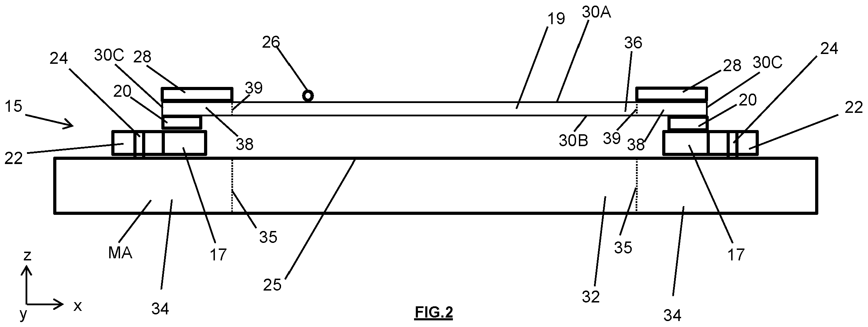

Figure 2 is a more detailed cross-sectional view of the pellicle 15 and the patterning device MA shown in Figure 1. The pellicle 15 comprises the pellicle frame 17 (hereinafter referred to as frame) and the membrane 19. Although not shown in Figure 1, the pellicle 15 comprises a pellicle border 20. The border 20 can optionally be integral with, comprised in or physically separate from the membrane 19. The border 20 may be significantly thicker than the main portion of the membrane 19 and may be located around an outer perimeter (periphery) of the membrane 19. It is this border 20 which is attached to the frame 17. The frame 17 supports the pellicle 15 around a perimeter portion of the membrane 19 via the border 20. The border 20 may be glued to the frame 17 or may be attached in another manner. In embodiments, the membrane 19 and the border 20 are fabricated together (i.e. at the same time). In some embodiments, the border 20 may be integrated with the frame 17. It will be appreciated that, in other embodiments, the pellicle 15 may not comprise a border, i.e. the membrane 19 may be formed directly on the frame 17.

The frame 17 may include an engagement mechanism 22 configured to allow the frame 17 to be removably attachable to the patterning device MA (i.e. to allow the frame 17 to be attachable to and detachable from the patterning device MA). The engagement mechanism 22 is configured to engage with an attachment member 24 provided on the patterning device MA. The attachment member 24 may, for example, be a protrusion or a stud which extends from the patterning device MA. The engagement mechanism 22 may, for example, comprise a locking member (not shown) which engages with the attachment member 24 and secures the frame 17 to the patterning device MA.

A plurality of engagement mechanisms 22 and associated attachment members 24 may be provided. The engagement mechanisms 22 may be distributed around the frame 17. Associated attachment members may be distributed around the perimeter of the patterning device MA.

The patterning device MA has a patterned surface 25. A contamination particle 26 is schematically shown. The contamination particle 26 is incident upon the membrane 19 and is held by the membrane 19. The membrane 19 holds the contamination particle 26 sufficiently far from the patterned surface 21 of the mask MA so that it is not imaged onto substrates by the lithographic apparatus LA. A pellicle 15 may allow a mask pattern (on the patterning device MA) to be provided which is protected from contamination by the pellicle 15 such that the pattern produced using the mask remains substantially defect free during use.

The pellicle 15 may be constructed by depositing the membrane 19 directly on top of a substrate which is to provide the border 20. After depositing of the membrane 19 of the pellicle 15, the substrate may be selectively back-etched to remove a central portion of the substrate and leave only an outer perimeter to form the border 20 to support the membrane 19. Alternatively, material for the border 20 may be deposited. This may be better as it avoids the challenge and stress of selective removal.

The pellicle 15 may be suitable for use adjacent to the reticle MA within an EUV lithographic apparatus LA. In use, such a (reflective) MA is illuminated with EUV radiation, for example from the illumination system IL. It will be appreciated that the reticle MA is configured to impart the radiation beam received from the illumination system IL with a pattern in its cross-section to form a patterned radiation beam. A projection system collects the (reflected) patterned radiation beam and forms a (diffraction-limited) image of the reticle MA on a substrate (for example a resist coated silicon wafer). Any contamination on the reticle MA will, in general, alter the image formed on the substrate, leading to printing errors.

To avoid particle contamination of the reticles MA, the pellicle 15 is used to protect the reticle MA. As described, the pellicle 15 is disposed in front of the reticle MA and prevents particles 26 from the landing on the reticle MA. The membrane 19 of the pellicle 15 is disposed such that it is not sharply imaged by the projection system and therefore particles on the membrane 19 do not interfere with the imaging process. It is desirable for the membrane 19 to be sufficiently strong that it stops particles 26 from impinging on the reticle MA that would cause unacceptable printing errors but as thin as possible to reduce the absorption of EUV radiation by the membrane 19.

The pellicle 15 comprises a protective portion 28. In this embodiment, the protective portion 28 is provided at a periphery of, and on a first side 30A of, the membrane 19. The first side 30A may be considered to be a front side. That is, the side that the EUV radiation (EUV radiation beam B) is incident on from the radiation source SO and/or illumination system IL. The first side 30A is opposite the side of the membrane 19 facing the patterning device MA in use. The first side 30A is opposite the side of the membrane 19 attached to a pellicle frame 17. The border 20 is provided at a periphery of, and on a second side 30B of, the membrane 19. The second side 30B may be considered to be a back side. The second side 30B faces the patterning device MA in use. The second side 30B is attached to a pellicle frame 17 (i.e. via the border 20). In other embodiments, a (or the) protective portion may, alternatively or additionally, be provided on the back side of the membrane. For example, both sides (front [first] and back [second]) of the membrane may have protective portions on part of their surfaces. Furthermore, a protective portion may, alternatively or additionally, be provided on edges 30C of the membrane (i.e. edges that extend in the z direction). In addition, in embodiments (e.g. with a CNT membrane), a protective portion may be conformal (i.e. coated around the CNT tubes) or interstitial (i.e. inside spaces in the membrane). In general, the protective portion may be provided on any portion of the membrane that may need to be protected, e.g. from etching. In embodiments, the protective potion on the front side of the membrane may cover a different area to the protective portion on the back side of the membrane. The protective portion on the back side of the membrane may also cover the border.

The patterning device MA comprises an exposure region 32 and a non-exposure region 34 (delimited as shown by the dotted lines 35). That is, during imaging, the exposure region 32 will receive EUV radiation and the non-exposure region 34 will not. The exposure region 32 has an area (in the xy plane) which forms at least part of the patterned surface 25. The exposure region 32 may be predetermined based on the specific field size that is chosen or desired. The exposure region 32 may be a chosen mask exposure field. The exposure region 32 may be referred to as the mask imaging field. The exposure region 32 may be continuous, i.e. is a single area. The exposure region 32 may include a plurality of dies (not shown), with separation for kerf or metrology or a single die. The dies may be clustered. If it was considered that there were exposure regions for separate dies, the exposure regions may be contiguous.

The membrane 19 comprises a first portion 36 and a second portion 38 (delimited as shown by the dotted lines 39). The first portion 36 has a first area and the second portion 38 has a second area (i.e. in the xy plane). In embodiments, the first portion 36 corresponds to the predetermined exposure region 32 of the patterning device MA. That is, the first portion 36 is substantially the same size (i.e. has the same area) as the exposure region 32. Thus, similarly, the second portion 38 extends inwardly (towards the centre in the x direction) to the same extent as the non-exposure region 34. It will be appreciated that the non-exposure region 34 may extend further outwardly (away from the centre in the x direction) than the second portion 38 since the patterning device MA may be larger in the x direction than the membrane 19.

It will be appreciated that the first portion 36 may also be considered to be an exposed region and the second portion 38 may also be considered to be an unexposed region as only the first portion will receive EUV radiation during imaging. However, in some embodiments, the distinction between first portion 36 and second portion 38 may relate to the amount of EUV imaging radiation that is incident thereon. For example, the first portion 36 may receive a full (100%) of the maximum EUV power density whereas the second portion 38 may only receive a fraction (e.g. 50%) of the maximum EUV power density. In general, the second portion 38, in use, may receive EUV imaging radiation, but may only receive a fraction of the EUV imaging radiation (when compared to the amount received by the first portion 36).

As shown, the protective portion 28 is at the second portion 38 on a side of the membrane 19 (i.e. the front side of the membrane 19). The protective portion 28 is not at the first portion 36. In other words, the protective portion 28 is only on the second portion 38 and is not on the first portion 36. The protective portion 28 covers the second portion 38 and does not cover the first portion 36. It may be considered that the protective portion 28 only partially covers the membrane 19. Furthermore, that the protective portion 28 only covers the non-imaging area (i.e. the area of the second portion 38).

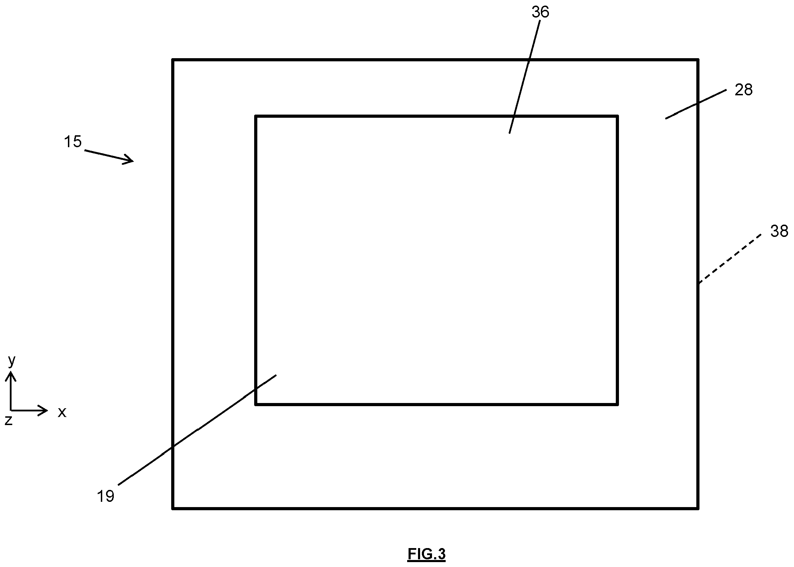

Figure 3 is a plan (front side) view of the pellicle 15 shown in Figure 2. The frame 17 and patterning device MA are not included for clarity. The first portion 36 of the membrane 19 forms a rectangular shape substantially in the centre of the membrane 19. The second portion 38 is underneath the protective portion 28 in Figure 2 so cannot be seen in this view. However, it will be understood that the second portion 38 surrounds the first portion 36 on each side (wrt the xy plane). The protective portion 28 is shown covering the second portion 38 (i.e. covering the same area). It will be appreciated that this is just an example and other sizes and/or shapes of the first portion, second portion and/or protective portion may be provided.

The pellicle 15 shown in Figures 2 and 3 is particularly advantageous, as now discussed.

One particularly promising material for use as a pellicle membrane in an EUV lithographic apparatus is a fabric or membrane formed from carbon nanotubes (CNTs). Such a CNT pellicle is a porous material and, therefore, can provide very high EUV transmission (of >98%). Furthermore, CNT pellicles also provide very good mechanical stability and can therefore be fabricated at small thicknesses, whilst remaining robust against mechanical failure. However, a low pressure hydrogen gas is typically provided within the lithographic apparatus, which forms a hydrogen plasma in the presence of the EUV radiation (during exposure). The plasma is present in the lithographic apparatus LA specifically to remove carbon deposited in the vacuum onto mirror surfaces. However, this can lead to etching of the CNT membranes themselves. It has been found that hydrogen ions and hydrogen free radicals from the hydrogen plasma can etch pellicles formed from CNTs, limiting the potential lifetime of the pellicle and blocking commercial implementation of CNT pellicles.

In order to mitigate such etching of CNT pellicles, it has previously been proposed to provide such CNT pellicles with a protecting, capping layer (a coating). However, it is desirable to minimize the absorption of EUV radiation by the pellicle and including a capping layer will increase the EUV transmission loss. In addition, coatings on CNT membranes are sensitive to temperature and will not survive (at least for a desired amount of time) in a high-source power lithographic apparatus LA. Furthermore, a difference between the refractive indices of carbon and suitable capping layers is typically larger than a difference between the refractive indices of carbon and the vacuum. Therefore, such a capping layer will result in an increase in EUV flare (scattered light), which is undesirable as it reduces image quality. For the CNT pellicle or any pellicle based on carbon, the hydrogen plasma in the lithographic apparatus LA will eventually limit lifetime.

The interaction of hydrogen ions with carbon materials is described quantitatively in the following two published papers, the contents of which are hereby incorporated by reference: (1) J. Roth, C. Garcia-Rosales, "Analytic description of the chemical erosion of graphite by hydrogen ions", Nucl. Fusion 1996, 36/12, 1647 - 1659; and (2) J. Roth, C. Garcia-Rosales, "Corrigendum - Analytic description of the chemical erosion of graphite by hydrogen ions", Nucl. Fusion 1997, 37, 897. This quantitative description of the interaction of hydrogen ions with carbon materials may be referred to as Roth-Garcia-Rosales (RGR) model. The RGR model can be used to predict an etch yield of carbon materials as function of the temperature for the typical hydrogen ion energies encountered within the lithographic apparatus such as, for example, ion energies form 1-30 eV. Within an EUV lithographic apparatus a typical hydrogen ion flux incident on the pellicle may be of the order of 1 · 1019 m-2 · s-1. Within an EUV lithographic apparatus a typical hydrogen ion flux incident on the pellicle may be within a couple of orders of magnitude of 1 · 1019 m-2 · s-1 (for example from 1018 m-2 · s-1 to 1020 m-2 · s-1).

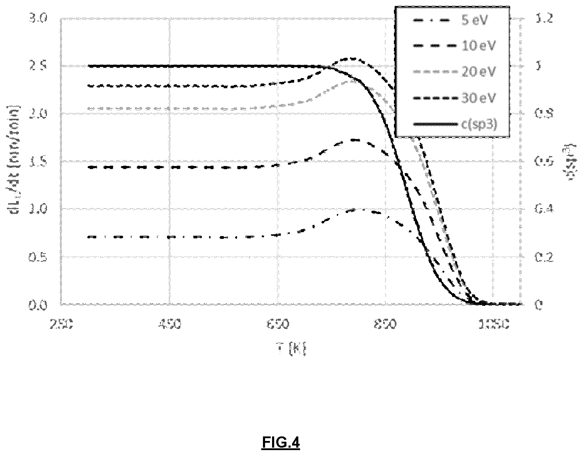

Figure 4 shows an expected etching rate for hydrogen etching of carbon as a function of temperature for a hydrogen ion flux of 1.5 - 1019 m-2 · s-1 for four different ion energies: 5 eV, 10 eV, 20 eV and 30 eV. The figure shows an sp3 carbon concentration as a function of temperature. It can be seen that for these typical ambient conditions in the lithographic apparatus LA, it is expected that for a pellicle formed purely from CNTs the hydrogen etching rate of the pellicle falls to a negligible level at a temperature of around 1050 K. However, it will be appreciated by the skilled person that under different conditions a different minimum temperature may be desirable.

The inventors of the present invention have realized that the etching of carbon by hydrogen ions and free radicals is temperature dependent. In particular, the inventors have realized that the carbon etching rate is higher at low and intermediate temperatures but the carbon etching rate falls to a negligible level at sufficiently high temperatures. The inventors have also realized that whilst a central portion of a membrane 19 within an EUV lithographic scanner LA may reach a sufficiently high temperature that hydrogen etching will be negligible (at least part of the time), a periphery of the membrane 19 will typically remain below this temperature and will therefore be more susceptible to hydrogen etching. That is, the CNT membranes will be heated to a temperature that actually limits the hydrogen plasma etch rate. This essentially creates multiple zones for the membrane 19, which we have referred to as the first portion 36 and the second portion 38. Although, in embodiments, the first portion 36 and the second portion 38 are, respectively, relatively hotter (exposed) and relatively cooler (unexposed) areas, it will be appreciated that, in other embodiments, the first portion 36 and second portion 38 (different zones) may be defined by other characteristics. Furthermore, the different zones (i.e. first portion 36 and second portion 38) may have different sizes and shapes as required. In embodiments, there may be a plurality of first portions 36 and/or a plurality of second portions 38. They may be separated, e.g. two first portions 36 may be separated by a second portion 38 and vice versa.

To maximize lifetime in the scanner and performance, it is important to tailor each CNT pellicle zone (or portion) for its use. The most-exposed region (the first portion 36) of the membrane will be over the reticle exposure field. The least-exposed region (the second portion 38) is over the frame region and has less stringent optical requirements.

Advantageously, the pellicle 15 shown in Figures 2 and 3 provides the additional protective portion 28 on the second portion 38 of (a front side 30A of) the membrane 19 that: (a) is most at risk from hydrogen etching; and (b) in use, does not receive EUV radiation. This allows the lifetime of the pellicle 15 to be increased without affecting the performance of the lithographic apparatus LA.

In some embodiments, the protective portion 28 is provided on a portion of the membrane 19 that, in use, does not receive EUV radiation (during imaging [exposure]). The first portion 36 is exposed to EUV radiation (during imaging) and thus is heated. The second portion 38 is not exposed to EUV radiation (during imaging) and consequently is not heated. Thus, the second portion 38 needs to be protected to extend lifetime. It will be appreciated that the second portion 38 does not necessarily need to be exactly lined up with the exposure region 32 of the patterning device MA, i.e. it may be substantially corresponding. For example, due to heat transfer from the EUV imaging radiation, there may be part of the membrane 19 a distance away (e.g. 0.25-2mm) from the part that is exposed to the (full) EUV imaging radiation, that does not suffer from etching (or at least suffers to an extent that is not problematic for lifetime considerations). It will be understood that where reference is made to the second portion 38 not receiving (full EUV imaging radiation) or the first portion 36 corresponding to a predetermined exposure region 32 of a patterning device MA, the position of the second portion 38, and thus the position of the protective portion 28, may take these distances into account. That is, the second portion 38 may start exactly where the exposure region ends or may start a distance (e.g. 0.25-2mm) away from the exposure region (i.e. towards the edge of the membrane 19) that takes into account this heat transfer.

The protective portion 28 is provided on the membrane 19 such that it coincides with the border 20. That is, the protective portion 28 overlaps with the border 20 (but the border 20 is provided on the opposite side 30B of the membrane 19). Since the protective portion 28 covers all of the second portion 38 and the border 20 does not cover all of the second portion 38 (on the other side), the protective portion 28 extends into part of the membrane 19 that does not coincide with the border 20. That is, the protective portion 28 also extends partially inwards onto a region of the membrane 19 that is not attached to the border 20.. In some embodiments, the protective portion may be provided during pellicle manufacturing, rather than during manufacture of the mask. During pellicle manufacturing the pellicle may not have been matched to a reticle or field yet. However, during pellicle manufacturing, the pellicle may be produced with certain standard field size, with the periphery coated with the protective portion accordingly, such as 100%, 80% etc.

In some embodiments, the protective portion 28 may be formed from a material that is suitable to protect a portion of the membrane 19 to which it is attached from hydrogen etching. For such embodiments, the protective portion 28 may comprise a capping material (which may be referred to as a coating). The capping material may be considered to cover the second portion 38. The capping material may only cover the second portion 38, i.e. may not cover the first portion 36. It may be considered that the coating only partially covers the membrane 19. The coating may only cover the non-imaging area of the membrane 19 (i.e. the second area of the second portion 38.) The coating is only applied outside the imaging field. The coating may not cover the imaging area of the membrane 19 (i.e. the first area of the first portion 36.) In embodiments, the protective portion 28 may be provided on the periphery on both (all) sides, i.e. the first side 30A and second side 30B (and edges 30C) of the membrane 19. This may provide increased protection when compared to the protective portion 28 only being on the first side 30A of the membrane 19.

The capping material may comprise any of the following materials either alone or in combination: carbon nanotubes, graphene, amorphous carbon, (low melting point metals (e.g. temperature below 600C), molybdenum (Mo), yttrium (Y), yttrium oxide (YₐO_{b}), aluminium oxide (Al₂O₃) (AlO₂), hafnium oxide (HfO₂), zirconium oxide (ZrO₂), ruthenium (Ru), platinum (Pt), gold (Au), zirconium nitride (ZrN), aluminium (Al), zirconium (Zr), silicon (Si), silicon carbide (SiC) silicon oxide (SiOₐ), boron (B), boron carbide (B₄C), boron nitride (BN), titanium (Ti), titanium nitride (TN). It will be appreciated that these are just examples and other materials may be used. The capping material may comprise a plurality of sublayers formed from different materials.

It will be appreciated that a greater thickness of such a capping material may be provided in the protective portion 28 (i.e. over the second portion 38) relative to the central first portion 36 of the membrane 19). That is, there may be some capping material over the first portion 36 in some embodiments. In some embodiments, there may be a relatively thick or thin coating in the exposed region and a relatively thick coating in the periphery. In general, there may be different extents of coverage and gradients may be possible. More generally, in embodiments, the first protective portion may be at or on the first portion but only to a lesser extent than at or on the second portion.

In some embodiments, the protective portion 28 may be formed from the same material as a bulk of the membrane 19. For such embodiments, the protective portion 28 may be an increased thickness of the bulk material (for example a CNT membrane), which may act as a sacrificial portion providing an increased thickness to be etched by the hydrogen. In this embodiment, it may be considered that the membrane 19 comprises the protective portion 28 and the protective portion 28 comprises the same material (e.g. carbon nanotubes) as the first portion 36 and the second portion 38.

In some embodiments, the membrane 19 may comprise a porous membrane. In some embodiments, the membrane 19 comprises nanotubes. For example, the membrane 19 may be a fabric formed from CNTs. This may be referred to as a carbon nanotube membrane. This is a particularly promising material for use as a pellicle membrane in an EUV lithographic apparatus.

There may a requirement that the first portion 36 provides >90% EUV transmission whereas the second portion 38 may only need to provide >80% EUV transmission. Furthermore, there may be requirement that the first portion 36 is tolerant (can withstand) high temperatures (>700 deg C) whereas the second portion 38 may only need to be tolerant to (withstand) lower temperatures (>500 deg C). There may be structures in a frame of the patterning device MA that are used for e.g. correction, alignment etc, and that may need to be visible to metrology sensors and so the second portion 38 may need to be transparent to EUV radiation to some extent, but not to the extent of the first portion 36. Furthermore, this EUV radiation that may be incident on the second portion 38 may be different from the EUV radiation used for imaging (i.e. EUV imaging radiation. For example, it may be not at the same high power as the EUV radiation for imaging, or may be a different wavelength and reduced dose relative to the EUV imaging radiation, and so will not damage (or destroy) the protective portion 28 (capping material).

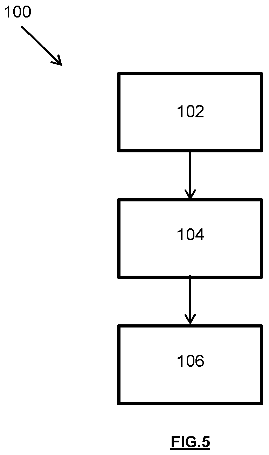

Some embodiments of the present disclosure relate to a method of forming a pellicle 15 for use in a lithographic apparatus such as the lithographic apparatus LA shown in Figure 1. Such a method 100 is illustrated schematically in Figure 5.

The method 100 comprises a step 102 of providing a membrane 19 comprising a first portion 36 and a second portion 38.

The method further comprises providing a protective portion 28 at the second portion 38 on a side or sides of the membrane 19, which may be by several different methods as will be explained.

The protective portion 28 may be provided by an additive method or a subtractive method as will be described in more detail.

In general, the method may comprise providing the first portion 36 to correspond to the predetermined exposure region 32 of the patterning device MA (i.e. that is for use with the pellicle 15).

An important aspect is that the pellicle 15 may be modified (i.e. by providing the protective portion 28) at the point of use (e.g. during fabrication of the patterning device MA and/or fabrication of a substrate W). This is once the reticle field size (e.g. max 104 × 132 mm² or smaller than full field size) associated with the mask (patterning device MA) is identified. In this case, the pellicle 15 may be selected and treated for desired design (with specific field) size. The treatment may be considered to be providing the pellicle 15 with the protective portion 28 at the second portion 38.

Mask fabrication may include e.g. qualifying the patterning device with CD measure, defect inspection etc; and mounting the pellicle onto the patterning device, which may include re-qualifying mask. Substrate (wafer) fabrication may include e.g. qualifying the pattering device with inspection and/or substrate exposures. The pellicle treatment (i.e. selecting and treating for desired design size) may be done at substrate W fabrication if the pellicle 15 is mounted on the patterning device MA there.

In other embodiments, the pellicle 15 may be provided with the protective portion 28 during fabrication of the pellicle 15. This may be when the membrane 19 is fabricated and the membrane 19 is attached to the frame 17. The membrane 19 may be fabricated or procured on a border 20.

For the additive method, the protective portion 28 may comprise a capping material (e.g. formed of a material such as those method above) - this may be referred to as a coating. In some embodiments, the method 100 may comprise a step 104 of masking the first portion 36 using a masking element. This means that the second portion 38 may be covered with the capping material without also covering the first portion 36. The masking element may be a shadow mask. Since the field size is mask specific then the shadow mask is adapted to chosen mask field size. In embodiments, the masking element corresponds to the predetermined exposure region 32 of the patterning device MA (i.e. that is for use with the pellicle 15).

The method 100 may comprise a step 106 of depositing the capping material over the second portion 38 (and the masking element) to cover the second portion 38. This results in the protective portion 28 being at the second portion 38 due to the first portion 36 being masked in step 104.

The capping material may be deposited using at least one of: thermal evaporation,, e-beam evaporation, e-beam deposition, pulsed laser deposition, atomic layer deposition and remote plasma sputtering.

For the subtractive method, the protective portion 28 may comprise a capping material (e.g. formed of a material such as those method above) - this may be referred to as a coating. The method may comprise applying the capping material over the first portion 36 and the second portion 38, and then removing the capping material from the first portion 36. Thus, the capping material would only be left over the second portion 38 (the cold area). This results in the protective portion 28 being at the second portion 38. That is, the membrane 19 is fully coated and then some of the coating (over the first portion 36) is selectively removed to leave only a partial coating.

The method may further comprise laser annealing, laser ablating, reactive ion etching, and/or lift-off the capping material from the first portion 36. This may be at high temperatures (e.g. a minimum of 500C, 600C or, more practically, 900C). It will be appreciated that these are just examples and other temperatures may be applicable.

The capping material may be a volatile or thermally unstable material suitable for being desorbed by EUV radiation (e.g. in a range of 200W to a few kWs, above 200W, above 600W or above 1kW EUV source power). For example, this may be during imaging (e.g. during exposure of the first field in the EUV lithographic apparatus) In embodiments, this may be during a "pre-sweep" because actual images are printed, since those require very stable conditions. Materials such as amorphous carbon (thick layer) or low melting point metals (e.g. Boron) show dewetting behaviour above a certain temperature where the compound desorbs and thus may be suitable for use as the capping material when using this method. For example, the temperature where the compound desorbs may be 500C, 600C, 700C, 800C, 900C, or lower or higher depending on the material.

For the subtractive method, the protective portion 28 may comprise the same material (e.g. carbon nanotubes) as the first portion 36 and the second portion 38. In this case, it may be considered that the membrane 19 comprises the protective portion 28.

The method may comprise providing the membrane 19 with a thickness (in the z direction) and then partially removing the first portion 36 to reduce the thickness of the first portion 36. The thickness of the protective portion 28 may be considered to be equivalent to the thickness that has been removed from the first portion 36. That is, after the removal, it may be considered that the first portion 36 has a reduced thickness with the protective portion 28 having a thickness which is equal to that removed from the first portion 36. It may be considered that the second portion 38 comprises the protective portion 28 (i.e. that the total thickness of the second portion 38 (including the protective portion 28) is equal to the thickness of the membrane 19 before part of the first portion 36 is removed.

The method may comprise etching the first portion 36 in hydrogen plasma, e.g. an RF plasma etch.

The protective portion 28 may be considered to be a sacrificial portion, i.e. providing an increased thickness to be etched by the hydrogen so that the second portion 38 does not get etched by the hydrogen.

The provision of the protective portion 28 only on the second portion 38, which is outside the imaging area, has an advantage that the protective portion 28 protects the membrane 19 against plasma etching whilst not increasing EUV transmission loss in the imaging area. The protective portion 28 is not required in the imaging area since the high-power EUV beam heats the membrane 19 to a high enough temperature to ensure that no, or only negligible, (CNT) etching takes place in the imaging area. Outside the imaging area, where the membrane is relatively cold in comparison to the imaging area, the EUV transmission values are irrelevant, or at least less important than in the imaging area. By protecting from plasma, the partial coating (protective portion 28 on the second portion 38) on the membrane 19 enables a longer lifetime of the parts of the (CNT) membrane 19 which are not heated during lithographic operation, and thus a longer lifetime of the membrane 19 as a whole.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A pellicle for use in a lithographic apparatus, the pellicle comprising:
a membrane, the membrane comprising a first portion and a second portion; and
a protective portion at the second portion on at least one side of the membrane.

2. The pellicle of claim 1, wherein the second portion, in use, does not receive EUV imaging radiation or receives only a fraction of the EUV imaging radiation received by the first portion.

3. The pellicle of either of claims 1 or 2, wherein the first portion substantially corresponds to a predetermined exposure region of a patterning device for use with the pellicle.

4. The pellicle of claim 3, wherein the first portion is substantially the same size as the predetermined exposure region of the patterning device.

5. The pellicle of any preceding claim, wherein the second portion is at a periphery of the membrane.

6. The pellicle of claim 5, wherein the pellicle comprises a border at the periphery of the membrane, wherein the second portion coincides with the border.

7. The pellicle of any preceding claim, wherein the protective portion comprises a material that is suitable to protect the second portion of the membrane from hydrogen etching.

8. The pellicle of any preceding claim, wherein the protective portion is on at least one of:
a first side and an opposite second side of the membrane; and
an edge of the membrane.

9. The pellicle of any preceding claim, wherein the protective portion comprises a capping material covering the second portion.

10. The pellicle of claim 9, wherein the capping material comprises at least one of: carbon nanotubes, graphene, amorphous carbon, (low melting point metals), molybdenum (Mo), yttrium (Y), yttrium oxide (YₐO_{b}), aluminium oxide (Al₂O₃) (AlO₂), hafnium oxide (HfO₂), zirconium oxide (ZrO₂), ruthenium (Ru), platinum (Pt), gold (Au), zirconium nitride (ZrN), aluminium (Al) zirconium (Zr), silicon (Si), silicon carbide (SiC) silicon oxide (SiOₐ), boron (B), boron carbide (B₄C), boron nitride (BN), titanium (Ti), and titanium nitride (TN).

11. The pellicle of any of claims 1-8, wherein the membrane comprises the protective portion and the protective portion comprises the same material as the first and second portions.

12. The pellicle of any preceding claim, wherein the membrane comprises carbon nanotubes.

13. A lithographic apparatus operable to form an image of a patterning device on a substrate using a radiation beam, the lithographic apparatus comprising a pellicle disposed in a path of the radiation beam, the pellicle according to any of the preceding claims.

14. A method for forming a pellicle for use in a lithographic apparatus, the method comprising:
providing a membrane comprising a first portion and a second portion,
providing a protective portion at the second portion on at least one side of the membrane.

15. The method of claim 14, further comprising providing the protective portion using an additive method or a subtractive method.

16. The method of claim 15, further comprising:
providing the protective portion using an additive method, wherein the protective portion comprises a capping material;
depositing the capping material over the second portion to cover the second portion.

17. The method of claim 16, further comprising masking the first portion using a masking element.

18. The method of claim 17, wherein the masking element substantially corresponds to a predetermined exposure region of a patterning device for use with the pellicle.

19. The method of any of claims 16-18, further comprising depositing the capping material using at least one of: thermal evaporation, e-beam evaporation, e-beam deposition, pulsed laser deposition, atomic layer deposition and remote plasma sputtering.

20. The method of claim 15, further comprising:
providing the protective portion using a subtractive method, wherein the protective portion comprises a capping material;
applying the capping material over the first portion and the second portion, and
removing the capping material from the first portion.

21. The method of claim 20, the method further comprising removing the capping material from the first portion using at least one of: laser annealing, laser ablating, reactive ion etching, and lift-off.

22. The method of either of claims 20 or 21, wherein the capping material is a volatile or thermally unstable material for being desorbed by EUV radiation.

23. The method of claim 15, further comprising providing the protective portion using a subtractive method including providing the membrane with a thickness, and partially removing the first portion to reduce the thickness of the first portion, wherein the membrane comprises the protective portion and the protective portion comprises the same material as the first and second portions.

24. The method of claim 23, further comprising etching the first portion in hydrogen plasma.

25. The method of claim any of claims 14-24, further comprising providing the protective portion on at least one of:
a first side and an opposite second side of the membrane; and
an edge of the membrane.

26. The method of any of claims 14-25, further comprising providing the first portion to substantially correspond to a predetermined exposure region of a patterning device for use with the pellicle.

27. The method of any of claims 14-26, further comprising providing the protective portion during at least one of fabrication of the pellicle, fabrication of a patterning device and fabrication of a substrate.
